# FASCICULE DE BREVET EUROPEEN

(11) **EP 4 199 051 B1**
(45) Date de publication et mention de la délivrance du brevet: **03.07.2024**
(21) Numéro de dépôt: 22214006.3
(22) Date de dépôt: 15.12.2022
(51) Int. Cl.: H01L 21/687, H01L 21/673

(54) **PLATEAU DE SUPPORT DE SUBSTRAT POUR DEPOT DE MATÉRIAU SUR DES BORDS D'UNE FACE DU SUBSTRAT**
SUBSTRATTRÄGERPLATTE ZUR MATERIALABSCHEIDUNG AUF DEN KANTEN EINES SUBSTRATS
SUBSTRATE SUPPORT TRAY FOR DEPOSITING MATERIAL ON EDGES OF A SUBSTRATE FACE

(30) Priorité: 16.12.2021 FR 2113722
(43) Date de publication de la demande: 21.06.2023
(73) Titulaire: Commissariat à l'énergie atomique et aux énergies alternatives, 75015 Paris (FR)
(72) Inventeur: FAVRE, Wilfried, 38054 Grenoble Cedex 09 (FR); JAY, Frédéric, 38054 Grenoble Cedex 09 (FR); THIRIOT, Benjamin, 38054 Grenoble Cedex 09 (FR)
(74) Mandataire: Brevalex

(56) Documents cités:
- KR-B1- 101 691 066
- US-A1- 2015 279 619

## Description

### DOMAINE TECHNIQUE

L'invention concerne le domaine du dépôt de matériaux, notamment pour la réalisation de cellules photovoltaïques. L'invention s'applique notamment pour la réalisation de cellules photovoltaïques à contacts passivés, et en particulier pour le dépôt de couches minces en bord de substrats dans le but de maximiser le transport latéral et le confinement optique des charges.

### ÉTAT DE LA TECHNIQUE ANTERIEURE

Une cellule photovoltaïque est réalisée à partir d'un substrat, ou plaquette ou wafer, de semi-conducteur sur lequel des couches minces sont déposées. Il existe de nombreux types de plateaux servant de support aux substrats pour réaliser ces dépôts.

Lorsqu'un dépôt doit être réalisé des deux côtés (faces avant et arrière) du substrat, par exemple dans un équipement de dépôt PVD (dépôt physique en phase vapeur), un plateau dit « ouvert », c'est-à-dire formant un accès à une partie de la face du substrat se trouvant du côté du plateau, est utilisé. Sur un tel plateau, le maintien du substrat est généralement réalisé au niveau des bords du substrat. Un tel plateau est par exemple décrit dans le document WO 2019/219127 A1.

Le document DE 10 2020 101 264 A1 décrit également un plateau « ouvert » comportant, en plus d'une partie de support des bords du substrat, un élément de support central masquant une ligne de séparation de deux parties du substrat. Un tel plateau est adapté pour la réalisation de cellules destinées à être coupées au niveau de la ligne de séparation, pour obtenir des demi-cellules.

Ces plateaux « ouverts » ne sont toutefois pas adaptés lorsqu'un matériau doit être déposé sur les bords d'une face du substrat.

US 2015/279619 décrit également un plateau de support de substrat selon l'art antérieur.

### EXPOSÉ DE L'INVENTION

Un but de la présente invention est de proposer un plateau de support, ou maintien, d'au moins un substrat permettant de réaliser un dépôt de matériau sur des bords d'une face du substrat sans recouvrir le reste de cette face par ce matériau.

Pour cela, la présente invention propose un plateau configuré pour supporter au moins un substrat lors d'un dépôt de matériau sur le substrat, comportant au moins :
- une surface de maintien pleine sur laquelle une face principale du substrat est destinée à être disposée lors du dépôt, et dont les dimensions sont inférieures à celles de la face principale du substrat de manière à ce que des bords de la face principale du substrat ne soient pas en contact avec la surface de maintien pleine ;
- des éléments de liaison formant des bras reliant mécaniquement la surface de maintien pleine à un cadre, ou châssis, du plateau.

Lors d'un dépôt de matériau sur le substrat maintenu dans un tel plateau, il est donc possible de localiser le matériau déposé contre les bords de la face principale du substrat qui se trouve du côté de la surface de maintien pleine, sans recouvrir de matériau le reste de cette face principale du substrat.

Le terme « substrat » désigne une plaquette, ou wafer, de matériau, par exemple de semi-conducteur tel que du silicium, sur laquelle un ou plusieurs éléments ont été éventuellement déposés (couches minces, contacts métalliques, etc.).

Un tel plateau est avantageusement utilisé pour déposer un revêtement antireflet, ou plus généralement une ou plusieurs couches minces de matériau(x), sur des bords d'une plaquette de silicium destinée à former une cellule photovoltaïque.

Le plateau comporte en outre des parties vides présentes autour de la surface de maintien pleine et en regard desquels les bords de la face principale du substrat sont destinés à être disposés.

La surface de maintien pleine peut avoir une forme carrée, et les éléments de liaison peuvent s'étendre depuis des coins de la surface de maintien pleine et/ou depuis des côtés de la surface de maintien pleine.

Les éléments de liaison peuvent avoir une épaisseur supérieure à celle de la surface de maintien pleine et peuvent former, du côté de la surface de maintien pleine sur lequel le substrat est destiné à être disposé, des parties en relief. De telles parties en relief permettent de guider et maintenir le substrat dans une position centrée sur la surface de maintien pleine.

Les parties en relief des éléments de liaison peuvent être amovibles. Ainsi, il est possible de modifier la forme et/ou les dimensions de ces parties en relief en fonction des dimensions du substrat maintenu par le plateau.

Le plateau peut être configuré pour maintenir plusieurs substrats lors d'un dépôt de matériau sur les substrats, et peut comporter plusieurs surfaces de maintien pleines espacées les unes des autres et maintenues mécaniquement les unes aux autres et au cadre par les éléments de liaison qui se rejoignent, et les surfaces de maintien pleines qui sont adjacentes au cadre peuvent être directement maintenues au cadre par une partie des éléments de liaison.

Le plateau peut être configuré pour supporter au moins un substrat de cellule photovoltaïque de forme standardisée.

L'invention concerne également un système comprenant au moins un plateau et au moins un substrat supporté par le plateau.

L'invention concerne également un procédé de dépôt de matériau sur des bords d'une face d'au moins un substrat, comportant au moins :
- disposition du substrat sur un plateau tel que décrit ci-dessus ;
- mise en place du plateau dans une chambre de dépôt d'un équipement de dépôt ;
- dépôt du matériau sur les bords de la face principale du substrat qui ne sont pas en contact avec la surface de maintien pleine.

L'équipement de dépôt peut être de type PVD, PECVD ou ALD.

L'invention concerne également un procédé de réalisation d'au moins une cellule photovoltaïque, comportant la mise en oeuvre d'un procédé de dépôt tel que décrit ci-dessus.

Dans l'ensemble du document, le terme « sur » est utilisé sans distinction de l'orientation dans l'espace de l'élément auquel ce rapporte ce terme. Par exemple, dans la caractéristique « sur une face du substrat », cette face du substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent un plateau configuré pour supporter au moins un substrat lors d'un dépôt de matériau sur le substrat, objet de la présente invention, selon un premier mode de réalisation ;
- la figure 3 représente une vue de profil d'un substrat disposé sur une surface de maintien pleine d'un plateau, objet de la présente invention ;
- les figures 4 et 5 représentent un plateau configuré pour supporter au moins un substrat lors d'un dépôt de matériau sur le substrat, objet de la présente invention, selon un deuxième mode de réalisation ;
- les figures 6 à 8 représentent différents exemples de réalisation d'éléments de liaison d'un plateau, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE REALISATION PARTICULIERS

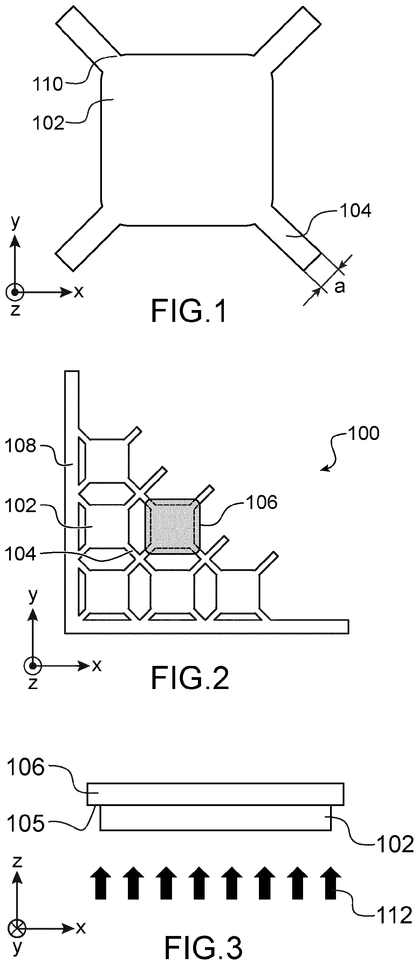

Un plateau 100, configuré pour supporter au moins un substrat lors d'un dépôt de matériau sur le substrat, selon un premier mode de réalisation est décrit ci-dessous en lien avec les figures 1 et 2. La figure 1 représente une vue de dessus d'une surface de maintien pleine 102 et d'éléments de liaison 104 du plateau 100 selon le premier mode de réalisation. La figure 2 représente une vue de dessus d'une partie du plateau 100 selon le premier mode de réalisation.

Le plateau 100 est configuré pour maintenir, ou supporter, au moins un substrat lors d'un dépôt de matériau sur le substrat. Dans l'exemple de réalisation décrit ici, le plateau 100 est configuré pour maintenir simultanément plusieurs substrats afin de déposer collectivement un matériau sur des bords 105 d'une face de chacun de ces substrats. Sur la figure 2, un des substrats soumis au procédé de dépôt et disposés sur le plateau 100 est représenté et est désigné par la référence 106.

Le substrat 106 peut correspondre à un substrat de cellule photovoltaïque de forme standardisée, par exemple une plaquette de format M12, M10, M9, M6, etc.

Le plateau 100 comporte donc plusieurs surfaces de maintien pleines 102 sur chacune desquelles une face principale d'un des substrats 106 est destinée à être disposée lors de la mise en oeuvre du dépôt. Les dimensions des surfaces 102 sont inférieures à celles de cette face principale du substrat 106 de manière à ce que des bords 105 de ladite face principale du substrat 106 ne soient pas en contact avec la surface 102. Ces bords 105 peuvent former, dans un plan parallèle à ladite face principale du substrat 106, un contour de largeur inférieure ou égale à 500 µm, et avantageusement comprise entre 100 µm et 500 µm.

Le plateau 100 peut comporter des parties vides présentes autour des surface de maintien pleines 102 et en regard desquels les bords 105 de la face principale de chaque substrat 106 sont destinés à être disposés.

Le nombre de surfaces de maintien 102 du plateau 100 est fonction des dimensions du plateau 100 et des dimensions de chacune des surfaces 102 (et donc des dimensions des substrats 106). A titre d'exemple, le nombre de surfaces de maintien 102 du plateau 100 peut être compris entre 4 et 48.

Le plateau 100 est par exemple réalisé majoritairement avec de l'inox ou du titane.

Le plateau 100 comporte également des éléments de liaison 104 formant des bras reliant mécaniquement chacune des surfaces 102 à un cadre 108 du plateau 100, soit directement pour les surfaces de maintien 102 qui sont adjacentes au cadre 108, soit par l'intermédiaire d'autres surfaces de maintien 102 et d'autres éléments de liaison 104 pour les surfaces de maintien 102 qui ne sont pas adjacentes au cadre 108. Sur l'exemple représenté sur la figure 2, cinq des surfaces de maintien 102 représentées sont adjacentes au cadre 108 et sont reliées mécaniquement à celui-ci par l'intermédiaire d'éléments de liaison 104, et une des surfaces de maintien 102 (celle sur laquelle le substrat 106 est représenté) n'est pas adjacente au cadre 108 et est reliée mécaniquement à celui-ci par l'intermédiaire des autres surfaces de maintien 102 et d'autres éléments de liaison 104. A l'intersection des éléments de liaison, il est possible de prévoir des éléments plus rigides afin de limiter ou supprimer les déformations mécaniques liées au poids des surfaces 102 et des substrats 106.

Ainsi, le plateau 100 comporte, dans cet exemple de réalisation plusieurs surfaces de maintien pleines 102 espacées les unes des autres et maintenues mécaniquement les unes aux autres et au cadre 108 par les éléments de liaison 104 qui se rejoignent.

Dans l'exemple de réalisation représenté sur les figures 1 et 2, chacune des surfaces de maintien 102 a une forme carrée, et les éléments de liaison s'étendent depuis quatre coins 110 de la surface de maintien 102.

Afin de minimiser la surface du ou des substrats 106 qui sera masquée par les éléments de liaison 104 lors du dépôt de matériau, la largeur (notée « a » sur la figure 1) des éléments de liaison 104 est choisie comme étant la plus petite possible, tout en veillant à ce que cette largeur soit suffisante pour avoir un maintien mécanique suffisant de la ou des surfaces 102 et du ou des substrats 106 disposés sur celle(s)-ci.

Le plateau 100 est utilisé notamment lors de la mise en oeuvre d'un procédé de dépôt de matériau sur les bords 105 d'une face d'au moins un substrat 106, le procédé comportant au moins la mise en oeuvre des étapes suivantes :
- disposition du substrat 106 sur le plateau 100 ;
- mise en place du plateau 100 dans une chambre de dépôt d'un équipement de dépôt par exemple de type PVD, PECVD ou ALD ;
- dépôt du ou des matériaux sur les bords 105 de la face principale du substrat 106 qui ne sont pas en contact avec la surface 102.

Le plateau 100 est avantageusement utilisé pour déposer un ou plusieurs matériaux sur des substrats 106 destinés à former des cellules photovoltaïques, par exemple de type à contacts passivés. Le substrat 106 peut notamment correspondre à une plaquette, ou wafer, de silicium, et le matériau déposé sur les bords 105 du substrat 106 peut notamment correspondre à un matériau antireflet, ou plus généralement une ou plusieurs couches minces de matériau(x).

La figure 3 représente une vue de profil du substrat 106 disposé sur la surface 102 lors de la mise en oeuvre du dépôt de matériau sur les bords 105 du substrat 106. Les flèches portant la référence 112 représentent le matériau à déposer sur les bords 105 et envoyé vers la face principale du substrat 106 disposée contre la surface 102 et qui inclut les bords 105.

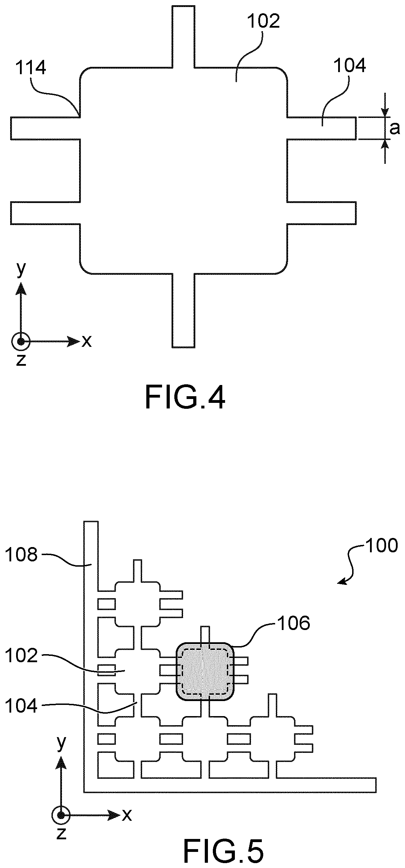

Un plateau 100 de maintien de substrat selon un deuxième mode de réalisation est décrit ci-dessous en lien avec les figures 4 et 5. La figure 4 représente une vue de dessus d'une surface de maintien pleine 102 et d'éléments de liaison 104 du plateau 100 selon le deuxième mode de réalisation. La figure 5 représente une vue de dessus d'une partie du plateau 100 selon le deuxième mode de réalisation.

Par rapport au premier mode de réalisation précédemment décrit, les éléments de liaison 104 s'étendent depuis des côtés 114 de la surface de maintien pleine. Les autres caractéristiques du plateau 100 selon ce deuxième mode de réalisation sont similaires à celles précédemment décrites pour le premier mode de réalisation.

Quelle que soit la configuration du plateau 100 (premier ou deuxième mode de réalisation ou autre), les éléments de liaison 104 ont avantageusement une épaisseur supérieure à celle de la surface 102 et forment, du côté de la surface 102 sur lequel le substrat 106 est destiné à être disposé, des parties en relief 116. Ainsi, les éléments de liaison 104 permettent un bon centrage du substrat 106 sur la surface 102, à la fois en guidant le substrat 106 lors de la disposition du substrat 106 sur la surface 102, et également en maintenant ce substrat 106 dans sa position centrée sur la surface 102 lorsque le plateau 100 est déplacé.

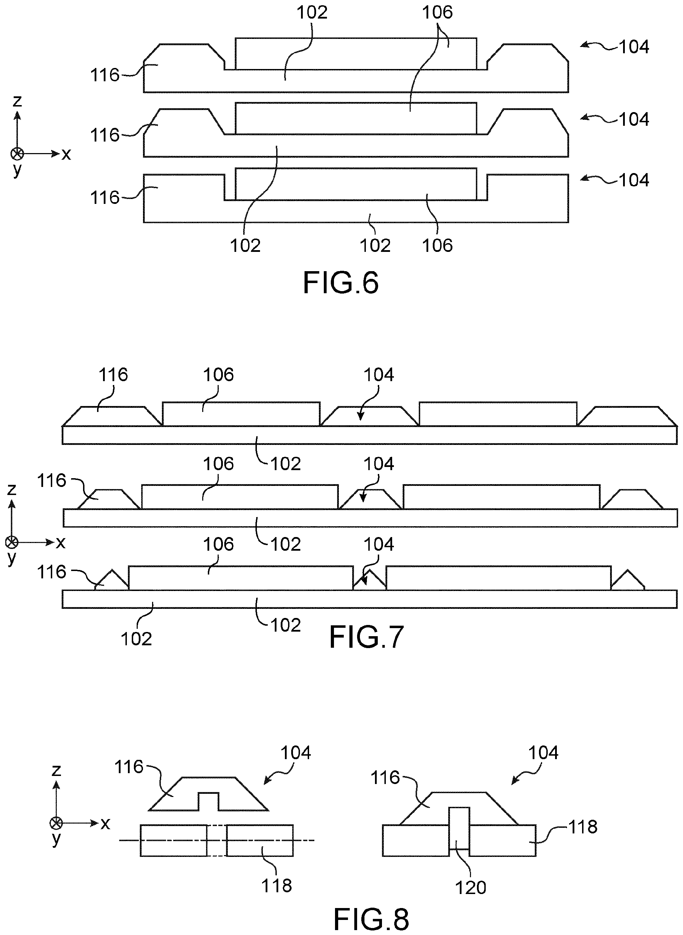

La figure 6 représente trois exemples de réalisation de tels éléments de liaison 104 comportant des parties en relief 116. Le profil de ces parties en relief 116 est par exemple de forme pyramidale, pyramidale tronquée, rectangulaire, polygonale, ou d'une toute autre forme.

La forme des éléments de liaison 104, et notamment des parties en relief 116, peut notamment être choisie en fonction de la taille du ou des substrats 106.

La figure 7 représente trois exemples de réalisation d'éléments de liaison 104 dont les parties en relief 116 ont des formes et des dimensions différentes adaptées pour des substrats 106 de différentes dimensions. Pour un espace de dimensions données, les dimensions des parties en relief 116 des éléments de liaison 104 peuvent ainsi être plus grandes lorsque les substrats 106 sont plus petits.

Quelle que soit la forme et les dimensions des éléments de liaison 104, les parties en relief 116 des éléments de liaison 104 peuvent être amovibles. Ainsi, il est possible de choisir ces parties en relief 116 en fonction de la forme et/ou des dimensions du ou des substrats 106 sur lesquels le dépôt est réalisé. En reprenant les exemples de réalisation représentés sur la figure 7, il est possible de choisir, en fonction des dimensions des substrats 106, les parties en relief 116 dont les dimensions s'adaptent le mieux à celles des substrats 106.

La figure 8 représente un exemple de réalisation d'un tel élément de liaison 104 comprenant une partie en relief 116 amovible et qui est fixée à une partie fixe 118 de l'élément de liaison 104 par un élément de maintien 120 traversant la partie fixe 118. D'autres types de fixation des parties en relief 116 aux parties fixes 118 des éléments de liaison 104 peuvent être envisagées.

## Revendications

1. Plateau (100) configuré pour supporter au moins un substrat (106) lors d'un dépôt de matériau (112) sur le substrat (106), comportant au moins :
- une surface de maintien pleine (102) contre laquelle une face principale du substrat (106) est destinée à être disposée lors du dépôt, et dont les dimensions sont inférieures à celles de la face principale du substrat (106) de manière à ce que des bords (105) de la face principale du substrat (106) ne soient pas en contact avec la surface de maintien pleine (102) ;
- des parties vides présentes autour de la surface de maintien pleine (102) et en regard desquels les bords (105) de la face principale du substrat (106) sont destinés à être disposés ;
- un cadre (108) ;
- des éléments de liaison (104) formant des bras reliant mécaniquement la surface de maintien pleine (102) au cadre (108) du plateau (100).

2. Plateau (100) selon la revendication 1, dans lequel la surface de maintien pleine (102) a une forme carrée, et dans lequel les éléments de liaison (104) s'étendent depuis des coins (110) de la surface de maintien pleine (102) et/ou depuis des côtés (114) de la surface de maintien pleine (102).

3. Plateau (100) selon l'une des revendications précédentes, dans lequel les éléments de liaison (104) ont une épaisseur supérieure à celle de la surface de maintien pleine (102) et forment, du côté de la surface de maintien pleine (102) sur lequel le substrat (106) est destiné à être disposé, des parties en relief (116).

4. Plateau (100) selon la revendication 3, dans lequel les parties en relief (116) des éléments de liaison (104) sont amovibles.

5. Plateau (100) selon l'une des revendications précédentes, configuré pour maintenir plusieurs substrats (106) lors d'un dépôt de matériau (112) sur les substrats (106), comportant plusieurs surfaces de maintien pleines (102) espacées les unes des autres et maintenues mécaniquement les unes aux autres et au cadre (108) par les éléments de liaison (104) qui se rejoignent, et dans lequel les surfaces de maintien pleines (102) qui sont adjacentes au cadre (108) sont directement maintenues au cadre (108) par une partie des éléments de liaison (104).

6. Plateau (100) selon l'une des revendications précédentes, dans lequel le plateau (100) est configuré pour supporter au moins un substrat (106) de cellule photovoltaïque de forme standardisée.

7. Système comprenant au moins un plateau (100) selon l'une des revendications précédentes et au moins un substrat (106) supporté par le plateau (100).

8. Procédé de dépôt de matériau (112) sur des bords (105) d'une face d'au moins un substrat (106), comportant au moins :
- disposition du substrat (106) sur un plateau (100) selon l'une des revendications 1 à 6 ;
- mise en place du plateau (100) dans une chambre de dépôt d'un équipement de dépôt ;
- dépôt du matériau (112) sur les bords (105) de la face principale du substrat (106) qui ne sont pas en contact avec la surface de maintien pleine (102) du plateau (100).

9. Procédé selon la revendication 8, dans lequel l'équipement de dépôt est de type PVD, PECVD ou ALD.

10. Procédé de réalisation d'au moins une cellule photovoltaïque, comportant la mise en oeuvre d'un procédé de dépôt selon l'une des revendications 8 ou 9, et dans lequel le substrat (106) utilisé est un substrat de cellule photovoltaïque de forme standardisée.

## Patentansprüche

1. Platte (100), die so konfiguriert ist, dass sie mindestens ein Substrat (106) bei einem Abscheiden von Material (112) auf das Substrat (106) trägt, mindestens umfassend:
- eine massive Haltefläche (102), an der eine Hauptseite des Substrats (106) bestimmungsgemäß beim Abscheiden angeordnet werden soll, und deren Abmessungen kleiner sind als die der Hauptseite des Substrats (106), sodass sich Kanten (105) der Hauptseite des Substrats (106) nicht mit der massiven Haltefläche (102) in Kontakt befinden;
- leere Teile, die um die massive Haltefläche (102) herum vorhanden sind und denen zugewandt die Kanten (105) der Hauptseite des Substrats (106) bestimmungsgemäß angeordnet werden sollen;
- einen Rahmen (108);
- Verbindungselemente (104), die Arme bilden, die die massive Haltefläche (102) mechanisch mit dem Rahmen (108) der Platte (100) verbinden.

2. Platte (100) nach Anspruch 1, wobei die massive Haltefläche (102) eine quadratische Form aufweist, und wobei sich die Verbindungselemente (104) von Ecken (110) der massiven Haltefläche (102) und/oder von Seiten (114) der massiven Haltefläche (102) aus erstrecken.

3. Platte (100) nach einem der vorstehenden Ansprüche, wobei die Verbindungselemente (104) eine Dicke aufweisen, die größer ist als die der massiven Haltefläche (102), und auf der Seite der massiven Haltefläche (102), auf der das Substrat (106) bestimmungsgemäß angeordnet werden soll, erhabene Teile (116) bilden.

4. Platte (100) nach Anspruch 3, wobei die erhabenen Teile (116) der Verbindungselemente (104) abnehmbar sind.

5. Platte (100) nach einem der vorstehenden Ansprüche, die so konfiguriert ist, dass sie mehrere Substrate (106) bei einem Abscheiden von Material (112) auf die Substrate (106) hält, mehrere massive Halteflächen (102) umfassend, die voneinander beabstandet sind und durch die Verbindungselemente (104), die zusammentreffen, mechanisch aneinander und am Rahmen (108) gehalten werden, und wobei die massiven Halteflächen (102), die an den Rahmen (108) angrenzen, durch einen Teil der Verbindungselemente (104) direkt am Rahmen (108) gehalten werden.

6. Platte (100) nach einem der vorstehenden Ansprüche, wobei die Platte (100) so konfiguriert ist, dass sie mindestens ein Photovoltaikzellen-Substrat (106) von standardisierter Form trägt.

7. System, das mindestens eine Platte (100) nach einem der vorstehenden Ansprüche und mindestens ein Substrat (106) umfasst, das von der Platte (100) getragen wird.

8. Verfahren zum Abscheiden von Material (112) auf Kanten (105) einer Seite mindestens eines Substrats (106), das mindestens umfasst:
- Anordnen des Substrats (106) auf einer Platte (100) nach einem der Ansprüche 1 bis 6;
- Platzieren der Platte (100) in einer Abscheidekammer einer Abscheideanlage;
- Abscheiden des Materials (112) auf die Kanten (105) der Hauptseite des Substrats (106), die sich nicht mit der massiven Haltefläche (102) der Platte (100) in Kontakt befinden.

9. Verfahren nach Anspruch 8, wobei die Abscheideanlage vom Typ PVD, PECVD oder ALD ist.

10. Verfahren zur Herstellung mindestens einer Photovoltaikzelle, das das Umsetzen eines Abscheideverfahrens nach einem der Ansprüche 8 oder 9 umfasst, und wobei das verwendete Substrat (106) ein Photovoltaikzellen-Substrat von standardisierter Form ist.

## Claims

1. A plate (100) configured to support at least one substrate (106) during a deposition of material (112) on the substrate (106), including at least:
- a solid holding surface (102) against which a main face of the substrate (106) is intended to be disposed during deposition, and the dimensions of which are less than those of the main face of the substrate (106) so that the edges (105) of the main face of the substrate (106) are not in contact with the solid holding surface (102);
- empty parts present around the solid holding surface (102) and facing which the edges (105) of the main face of the substrate (106) are intended to be disposed;
- a frame (108);
- connecting elements (104) forming arms mechanically connecting the solid holding surface (102) to the frame (108) of the plate (100).

2. The plate (100) according to claim 1, wherein the solid holding surface (102) has a square shape, and wherein the connecting elements (104) extend from corners (110) of the solid holding surface (102) and/or from sides (114) of the solid holding surface (102).

3. The plate (100) according to one of the preceding claims, wherein the connecting elements (104) have a thickness greater than that of the solid holding surface (102) and form, on the side of the solid holding surface (102) on which the substrate (106) is intended to be disposed, raised parts (116).

4. The plate (100) according to claim 3, wherein the raised parts (116) of the connecting elements (104) are removable.

5. The plate (100) according to one of the preceding claims, configured to hold several substrates (106) during a deposition of material (112) on the substrates (106), including several solid holding surfaces (102) spaced apart from each other and mechanically held to each other and to the frame (108) by the connecting elements (104) which meet, and wherein the solid holding surfaces (102) which are adjacent to the frame (108) are directly held to the frame (108) by part of the connecting elements (104).

6. The plate (100) according to one of the preceding claims, wherein the plate (100) is configured to support at least one photovoltaic cell substrate (106) of standardized shape.

7. A system comprising at least one plate (100) according to one of the preceding claims and at least one substrate (106) supported by the plate (100).

8. A method for depositing material (112) on edges (105) of one face of at least one substrate (106), including at least:
- disposing the substrate (106) on a plate (100) according to one of claims 1 to 6;
- placing the plate (100) in a deposition chamber of a deposition equipment;
- depositing the material (112) on the edges (105) of the main face of the substrate (106) which are not in contact with the solid holding surface (102) of the plate (100).

9. The method according to claim 8, wherein the deposition equipment is of the PVD, PECVD or ALD type.

10. The method for producing at least one photovoltaic cell, including the implementation of a deposition method according to one of claims 8 or 9, and wherein the substrate (106) used is a photovoltaic cell substrate of standardized form.
